# EUROPEAN PATENT SPECIFICATION

(11) **EP 3 884 286 B1**
(45) Date of publication and mention of the grant of the patent: **27.12.2023**
(21) Application number: 19805974.3
(22) Date of filing: 21.11.2019
(51) Int. Cl.: G01R 31/72

(54) **SHORT CIRCUIT DETECTION OF AN ELECTROMAGNETIC INDUCTION COIL**
KURZSCHLUSSERKENNUNG EINER ELEKTROMAGNETISCHEN INDUKTIONSSPULE
DÉTECTION DE COURT-CIRCUIT D'UNE BOBINE D'INDUCTION ÉLECTROMAGNÉTIQUE

(30) Priority: 21.11.2018 EP 18207618; 15.04.2019 EP 19169348
(43) Date of publication of application: 29.09.2021
(73) Proprietor: Prodrive Technologies Innovation Services B.V., 5692 EM Son en Breugel (NL)
(72) Inventor: BRON, Ben, 5692 EM Son (NL); VOS, Danny, 5692 EM Son (NL)
(74) Representative: AWA Benelux
(86) International application number: PCT/EP2019/082128
(87) International publication number: WO 2020/104607

(56) References cited:
- JP-A- 2011 252 752
- US-A- 4 973 912
- US-B1- 6 236 220

## Description

### Technical field

The present invention is related to an apparatus comprising a short circuit detection device for detecting short circuit of an electromagnetic induction coil. The present invention can be used in basically any application such as for example motors (rotating and linear), transformers or inductors.

### Background art

US 3863109 describes a method of detecting a short circuit by means of an additional sensing coil or hall device. A short circuit of the high voltage side is detected by a separate low voltage side by using a secondary coil or hall device for the short circuit detection. A disadvantage is that the primary coil needs to be active/carrying a current in order to detect a short circuit with the secondary coil or hall device.

JP2013061310A and JP2011252752A describe a method of detecting a short circuit in a transformer by measuring the gain of the transfer function of the secondary winding at a single frequency, located near the first resonance frequency of the transformer, while the primary winding of the transformer is open. A disadvantage of this approach is that it requires knowledge of the resonance frequency of the transformer. An additional disadvantage is that the transfer function near the resonance frequency of the transformer is heavily influenced by parasitic capacitances between windings.

US 6236220 describes a method for testing an inductive resonant circuit, particularly to test whether an antenna circuit of a contactless chip card is defective. The antenna coil of the resonant circuit is excited by inductive coupling using a test coil and excitation is sharply interrupted. A response signal generated by self-induction in the antenna coil and retransmitted to the test coil by inductive coupling is detected and analysed.

US 4973912 describes a device for determining a resistance value of a resistance of a secondary side LCR circuit. An exciter signal coupled into the LCR circuit from a primary side via inductively coupled coils is interrupted and retransmitted to the primary side and used for determining the resistance value by evaluating the time constant of the exciter response.

### Summary of the invention

In some critical applications, it is desired to be able to detect a short circuit of an electromagnetic induction coil without driving the coil directly. It is therefore an aim of the present invention to provide an apparatus comprising a detection device for detecting a short circuit of an electromagnetic induction coil of the apparatus which allows for safer operation of the apparatus.

It is further an aim of the present invention to provide an apparatus for detecting a short circuit of an electromagnetic induction coil with reduced complexity and/or less hardware. It is also an aim to provide such apparatuses which allow for detecting a short circuit of an electromagnetic induction coil with greater reliability, and which possibly allow for discriminating between different kinds of short circuits.

According to the present invention, there is therefore provided an apparatus as set out in the appended claims. The apparatus comprises at least one electromagnetic induction coil, and a detection device for detecting a short circuit in the at least one electromagnetic induction coil. The detection device comprises a detection coil independent of the at least one electromagnetic induction coil and a detection circuit coupled to the detection coil. The detection coil is arranged such that the detection coil is inductively coupled to the at least one electromagnetic induction coil. Advantageously, the detection coil is arranged in such a way with respect to the at least one electromagnetic induction coil, that a short circuit in the at least one electromagnetic induction coil causes a change in inductance of the detection coil. The detection circuit is configured to drive the detection coil in order to induce an electric current in the at least one electromagnetic induction coil.

According to the invention, the principle of the detection is based on a change in inductance of the detection coil due to a short circuit in the at least one electromagnetic induction coil. Depending on the number of turns that are forming the short circuit, the change in inductance will differ, advantageously giving the possibility to distinguish between different types of short circuit by the detection device.

With the above detection circuit, it becomes possible to detect a short circuit while the at least one electromagnetic induction coil is disabled and not operating. This increases safety. It is hence not required that the at least one electromagnetic induction coil must be driven in order to be able to detect a short circuit therein, since both electromagnetic induction coil and detection coil have independent circuits. Advantageously, the at least one electromagnetic induction coil is disconnected from power supply, and advantageously forms an open circuit during detection by the detection circuit. The detection circuit is advantageously configured to detect a change from the open circuited configuration of the at least one electromagnetic induction coil to a short circuit of one or more windings of the at least one electromagnetic induction coil.

A second advantage of having a separate circuit comprising the detection coil for the detection of the short circuit in the at least one electromagnetic induction coil, is the ability to separate between high voltage and low voltage. The detection circuit can be powered with a low voltage source and advantageously does not need to cross a high voltage barrier in order to detect a short circuit in the at least one (high voltage) electromagnetic induction coil, which further increases safety and decreases cost since the detection circuit can be made from low voltage components. The at least one electromagnetic induction coil and the detection coil can be seen as an isolated transformer, and the detection coil and the detection circuit can be completely situated at a low voltage side.

Advantageously, a winding ratio between the at least one electromagnetic induction coil and the detection coil is selected such that a voltage induced in the detection coil during operation of the at least one electromagnetic induction coil is 60 V or less. By so doing, the detection device remains at low voltage without risk of hazard or injury.

Advantageously, the detection circuit is configured to sense a signal representative of a magnetic flux induced in the detection coil due to the electric current induced in the at least one electromagnetic induction coil. The detection circuit can be implemented in different ways and is advantageously able to detect complete and/or partial short circuits on the at least one electromagnetic induction coil.

According to the present invention, the detection circuit is configured to determine a frequency of a second electric signal induced in the detection coil following application of a first electric signal to the detection coil. Application of the first electric signal induces a current in the electromagnetic induction coil. Either the electromagnetic induction coil, or the detection coil, or both can be formed as resonant tank circuits, due to provision of a physical capacitor and/or the presence of parasitic capacitances. This causes an oscillating current in the detection coil, the frequency of which can easily and reliably be detected. Advantageously, the frequency is determined by detecting zero crossings of the second electric signal. Such frequency detection is more precise and requires less hardware compared to amplitude based measurements as in the prior art. By way of example, amplitude based measurement would require the use of an A/D converter, and the use of an A/D converter can be dispensed with in frequency based measurements.

Further advantageous embodiments are set out in the dependent claims.

A method of detecting a short circuit in an electromagnetic induction coil by means of apparatuses according to the present invention is described herein as well. The method comprises operating the apparatus as described herein.

### Brief description of the figures

Aspects of the invention will now be described in more detail with reference to the appended drawings, wherein same reference numerals illustrate same features and wherein:
Figure 1 represents an electrical scheme of an apparatus comprising an electromagnetic induction coil and a detection circuit;
Figure 2 represents a graph showing the voltage at node X in Fig. 1 in various circumstances (with or without short circuit);
Figure 3 represents an electrical scheme of an apparatus according to the present invention comprising an electromagnetic induction coil coupled in a resonant circuit and a detection circuit;
Figure 4 represents a graph showing the voltage at node Y in Fig. 3 in various circumstances (with or without short circuit);
Figures 5A-B represent possible layouts of the detection coil and electromagnetic induction coil according to the present invention;
Figure 6 represents a linear motor comprising a plurality of stator coils and a detection device for each one of the stator coils.

### Description of embodiments

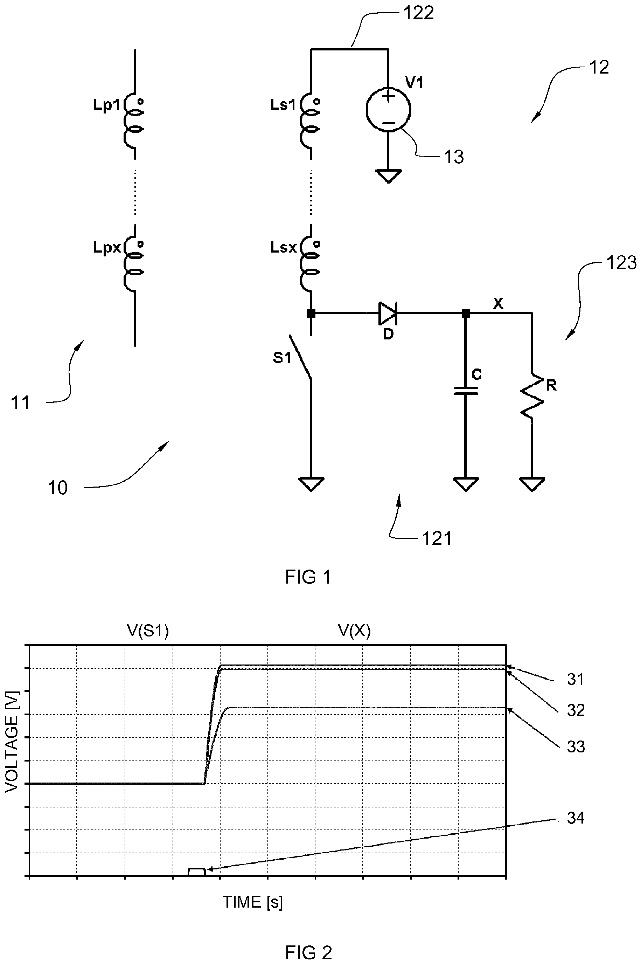

An example implementation of an apparatus for detecting a short circuit is shown in Fig. 1. Apparatus 10 comprises an application part 11 comprising an electromagnetic induction coil depicted as multiple coil windings Lp1-Lpx connected in series. The application part 11 can comprise one or more electromagnetic induction coils as required for the application and these will henceforth be referred to as application coil(s). Lp1-Lpx can e.g. be stator windings of an electric motor, a transformer, or any other device making use of electromagnetic induction coils. The application part 11 can be coupled in dedicated operating circuits as known in the art for the particular purpose. By way of example, the application part can be connected to a (high voltage) power supply. There is no need that the application part 11 be coupled in a circuit dedicated to short circuit detection, since this is taken care of by a detection device 12.

Detection device 12 comprises a detection coil having one or more windings Ls1-Lsx connected in series coupled to a detection circuit 121. The detection circuit 121 is configured to drive the detection coil Ls1-Lsx such that a current flows through the detection coil Ls1-Lsx. The current through the detection coil Ls1-Lsx induces a magnetic flux in the application coil Lp1-Lpx which in turn causes a current to flow in the application coil Lp1-Lpx. To this end, the detection coil Ls1-Lsx is advantageously arranged such that it is magnetically (inductively) coupled to the application coil(s) Lp1-Lpx in order that a current flowing through the application coil(s) induces a magnetic flux in the detection coil that can be measured.

It will be convenient to note that the number of turns or windings of the detection coil Ls1-Lsx can be selected as desired, e.g. to obtain a desired sensitivity of the detection circuit. Advantageously, the detection coil Ls1-Lsx is arranged such that an induced voltage in the detection circuit will be substantially lower than a voltage applied to the application coil during use (operation). This can be obtained by proper selection of the location where the detection coil is placed with respect to the application coil, or by proper selection of the number of windings of the detection coil in relation to the number of windings of the application coil.

Detection circuit 121 comprises a first circuit 122 referred to as driving circuit and a second circuit 123 referred to as measuring circuit. The driving circuit 122 comprises a switch S1 coupled in series with the detection coil Ls1-Lsx and a power supply 13. The measuring circuit 123 is coupled to the driving circuit 122 in order to measure an electric signal, such as a voltage, in the driving circuit 122.

By closing switch S1, in particular when the application coil is not in operating state, e.g. it is open circuited, a voltage step is applied over the detection coil Ls1 -Lsx. This causes a current to flow through the detection coil Ls1-Lsx, in turn inducing a magnetic flux and related current in the application coil Lp1-Lpx. When the switch S1 is opened, the formerly induced current in the application coil Lp1-Lpx will induce a magnetic flux in the detection coil Ls1-Lsx which is measured through measuring circuit 123. Measuring circuit 123 can be configured to measure the complex impedance, e.g. by evaluating the current through the detection coil Ls1-Lsx with switch S1 open.

Any appropriate voltage step can be contemplated. Alternatively, a pulse of given duration can be applied to switch S1, and the stored energy in the application coil Lp1-Lpx and detection coil Ls1-Lsx can be evaluated by measuring the voltage at node x. A complete or partial-short circuit of the application coil Lp1-Lpx will result in less stored energy and hence a lowered voltage at node X, as visualized in the graph of Fig. 2. In Fig. 2, numeral 34 refers to the closure of switch S1; numeral 31 refers to an exemplary voltage signal at node X in case no short-circuit is present in the application coil; numeral 32 refers to an exemplary voltage signal in case a partial short-circuit is present in the application coil; and numeral 33 refers to an exemplary voltage signal in case a complete short circuit of the application coil is present.

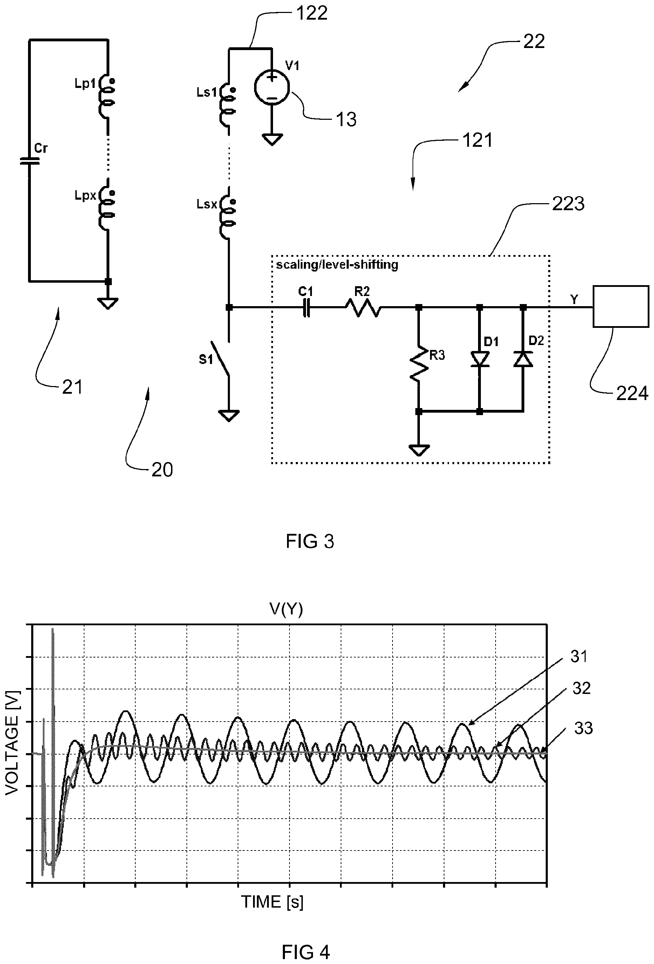

According to the present invention, the apparatus 10 of Fig. 1 is further improved as shown in Fig. 3. Referring to Fig. 3, apparatus 20 differs from apparatus 10 in that a capacitor Cr is added across the application coil Lp1-Lpx. Alternatively or in addition, a capacitor can be added across the detection coil Ls1-Lsx. This results in a resonant circuit being formed which advantageously transforms the impedance measurement problem of Fig. 1 into a frequency measurement problem, which improves the sensitivity and is easier to implement in digital logic. A scaling / level shifting network can be used as measuring circuit 223, which translates the voltages at node y to a level at which the timing of the zero crossings can be easily detected by a digital circuit, e.g. a counter circuit 224. The graph of Fig. 4 shows the voltage signals at node Y for same circumstances as in Fig. 2 (same voltage step applied). In Fig. 4, numeral 31 refers to an exemplary voltage signal at node Y in case no short-circuit is present in the application coil; numeral 32 refers to an exemplary voltage signal in case a partial short-circuit is present in the application coil; and numeral 33 refers to an exemplary voltage signal in case a complete short circuit of the application coil is present.

In some cases, the circuit of the application coil can comprise substantial parasitic capacitances, allowing to exploit these parasitic capacitances to form a resonant circuit. In these cases, the parasitic capacitances may act in replacement of the capacitor Cr, and capacitor Cr may be omitted from the circuit of Fig. 3.

During operation of the detection device 12, 22, the application coil Lp1-Lpx are advantageously not driven, e.g. they are advantageously disconnected from a power source. The detection device 12, 22 can furthermore comprise a computing and/or control unit configured to compare the measurement (of the impedance or the frequency) with a reference value representative of a no short-circuit condition of the application coil Lp1-Lpx. The reference value can be obtained by calibration or can be based on previous measurements. The control unit can furthermore be configured to emit a signal when a fault state of the at least one electromagnetic induction coil is detected. The signal can be operable, e.g. through appropriate relay, etc., to render the application coil inoperative.

The additional capacitor Cr can advantageously be selected with tight tolerances, instead of only relying on parasitic capacitances. Using such a circuit can significantly improve the reproducibility of the measurements and reduce inter-circuit variability. This offers the possibility to use pre-calculated limits for the no short-circuit condition.

The power supply 13 can be a low voltage power supply, operating at a safe voltage of 60 V DC or less, e.g. at 12 V DC. The detection circuit 121 should be able to withstand the voltage induced in the detection coil Ls1-Lsx while switch S1 is open and the application coil Lp1-Lpx is operating. This will of course depend on the particular application. One possibility is to increase the impedance in detection circuit 121 to appropriate values. Another possibility is to select the number of turns of the detection coil Ls1-Lsx in relation to the number of turns of the application coil Lp1-Lpx in order to mitigate the voltage induced in the detection coil Ls1-Lsx. This may also avoid interference with operation of the application coil Lp1-Lpx.

It will be convenient to note that during closure of switch S1, the circuit in which the application coil Lp1-Lpx is coupled can be open, e.g. the detection device 12, 22 is able to discriminate between a condition in which the application coil is open circuited (disabled) and a faulty condition in which there is a short circuit between one or more windings or turns of the application coil Lp1-Lpx.

During normal operation of the application part 11, the switch S1 advantageously remains open, and detection circuit 121 advantageously is not operated. By appropriate selection of the value of the impedance of the detection circuit, the current through the detection coil Ls1-Lsx can be minimized during operation of the application coil Lp1-Lpx.

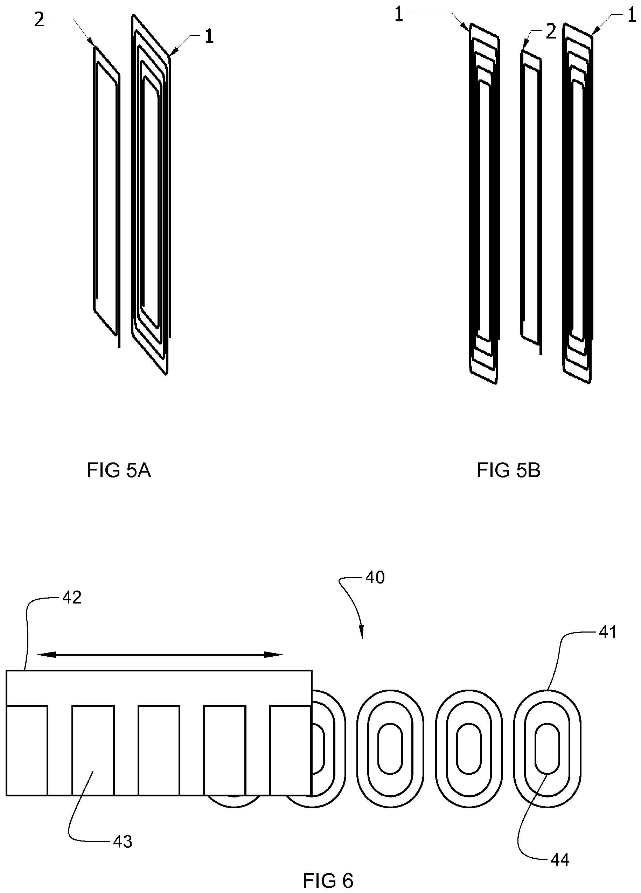

Referring to Figs. 5A and 5B, possible arrangements for the application coil 1 and the detection coil 2 are presented. Either one, or both the application coil 1 and the detection coil 2 can be formed of wound coils such as planar wound coils, i.e. comprising substantially coplanar windings (all windings arranged in substantially a same plane). The application coil 1 and the detection coil 2 can be arranged with their winding planes parallel to each other.

In Fig. 5B, the detection coil 2 is interposed between two application coils 1. The detection coil 2 can be arranged to detect a short circuit in both application coils.

Apparatuses according to the invention can refer to electric motors, such as rotary motors, with the application coil referring to e.g. a stator coil. Alternatively, the electric motor can be a linear motor, such as those used as actuators in magnetic lift systems. The linear motor can comprise stator coils and permanent magnet moving units. In the latter case, the application coil can refer to the stator coil, and the detection device is configured to detect a short circuit in the stator coil.

Referring to Fig. 6, a linear motor 40 can comprise a plurality of stator coils 41, which may be juxtaposed in order to drive the moving unit 42 provided with permanent magnets 43. Each stator coil 41 can refer to the application coil(s) Lp1-Lpx. A detection device 44, which can be any detection device as described herein, can be provided for each stator coil respectively. Alternatively, one detection device can be arranged to detect a short circuit in two or more adjacent stator coils, e.g. via the arrangement of Fig. 5B.

Short circuits may occur particularly in wound coils, e.g. non-printed coils, such as manufactured by winding conductive material such as strips or wire. These wound coils can have various forms (e.g. helical, planar). The fault mode is therefore particularly relevant for such a wound coil, such as a planar wound coil, that may be used as a stator coil of a linear motor for instance used for driving a magnetic lift. Furthermore, such coils used in applications requiring a high voltage are typically potted which renders some of the other short circuit detection methods (e.g. using ports of the coil) unsuitable.

The detection device can be configured to initiate a detection cycle at regular intervals in order to test the integrity of the application coil. By way of example, in the magnetic lift systems referred to above, some branches of the lift path may not be used frequently, and a regular detection of short circuits in the stator coils is useful while the path is not being used.

## Claims

1. Apparatus (20), comprising:
at least one electromagnetic induction coil (Lp1-Lpx), and
a detection device (22) for detecting a short circuit in the at least one electromagnetic induction coil,
wherein the detection device comprises a detection coil (Ls1-Lsx) independent of the at least one electromagnetic induction coil and a detection circuit (121) coupled to the detection coil,
wherein the detection coil (Ls1-Lsx) is arranged such that the detection coil is inductively coupled to the at least one electromagnetic induction coil (Lp1-Lpx), and
wherein the detection circuit (121) is configured to:
connect the detection coil (Ls1-Lsx) to a power supply (13) and apply a first electric signal to the detection coil in order to induce an electric current in the at least one electromagnetic induction coil (Lp1-Lpx), and
disconnect the detection coil (Ls1-Lsx) from the power supply (13), **characterised in that** the detection circuit is configured to determine a frequency of a second electric signal induced in the detection coil (Ls1-Lsx) following the first electric signal.

2. Apparatus of claim 1, wherein the detection circuit (121) is configured to sense a signal representative of a magnetic flux induced in the detection coil (Ls1-Lsx) due to the electric current induced in the at least one electromagnetic induction coil (Lp1-Lpx).

3. Apparatus of claim 1 or 2, wherein the at least one electromagnetic induction coil (Lp1-Lpx) and the detection coil (Ls1-Lsx) are electrically isolated.

4. Apparatus of any one of the preceding claims, comprising a controller configured to render the at least one electromagnetic induction coil inoperative in response to the detection device (12, 22) determining a fault state of the at least one electromagnetic induction coil (Lp1-Lpx).

5. Apparatus of any one of the preceding claims, further comprising a computing unit configured to compare a measurement of the frequency with a reference value representative of a no short-circuit condition of the at least one electromagnetic induction coil.

6. Apparatus of any one of the preceding claims, configured to operate the detection circuit (121) while the at least one electromagnetic induction coil (Lp1-Lpx) is in an inactive state.

7. Apparatus of claim 6, comprising a first power supply configured to be connected to the at least one electromagnetic induction coil (Lp1-Lpx), a second power supply (13) configured to be connected to the detection coil (Ls1-Lsx), and a controller configured to connect the detection coil to the second power supply while the at least one electromagnetic induction coil is disconnected from the first power supply, preferably wherein a voltage level of the first power supply is higher than a voltage level of the second power supply, preferably at least 50 V, more preferably 100 V higher, even more preferably at least 150 V higher, preferably wherein a voltage level of the second power supply (13) is 60 V or less, preferably between 5 V and 50 V.

8. Apparatus of any one of the preceding claims, wherein the first electric signal is a voltage step.

9. Apparatus of any one of the preceding claims, wherein the first electric signal is an impulse signal.

10. Apparatus of any one of the preceding claims, wherein one or both of the at least one electromagnetic induction coil and the detection coil is formed as a resonant circuit.

11. Apparatus of claim 10, wherein the detection circuit comprises a digital circuit configured to detect a timing of zero crossings of the second electric signal.

12. Apparatus of any one of the preceding claims, wherein the detection device (12, 22) comprises a printed circuit board and the detection coil (Ls1-Lsx) is formed by a conductive trace on the printed circuit board.

13. Apparatus of any one of the preceding claims, wherein the at least one electromagnetic induction coil (Lp1-Lpx) is a coil of an electric motor.

14. Apparatus of claim 13, being a linear motor, wherein the apparatus comprises a plurality of stator coils and a permanent magnet moving unit, wherein each of the plurality of stator coils comprises the at least one electromagnetic induction coil (Lp1-Lpx).

15. Apparatus of any one of the claims 1 to 12, wherein the at least one electromagnetic induction coil (Lp1-Lpx) is a coil of a transformer.

## Patentansprüche

1. Gerät (20), umfassend:
mindestens eine elektromagnetische Induktionsspule (Lp1-Lpx), und
eine Erfassungsvorrichtung (22) zum Erfassen eines Kurzschlusses in der mindestens einen elektromagnetischen Induktionsspule,
wobei die Erfassungsvorrichtung eine von der mindestens einen elektromagnetischen Induktionsspule unabhängige Erfassungsspule (Ls1-Lsx) und eine mit der Erfassungsspule gekoppelte Erfassungsschaltung (121) umfasst,
wobei die Erfassungsspule (Ls1-Lsx) so angeordnet ist, dass die Erfassungsspule induktiv mit der mindestens einen elektromagnetischen Induktionsspule (Lp1-Lpx) gekoppelt ist, und
wobei die Erfassungsschaltung (121) zu Folgendem konfiguriert ist:
Verbinden der Erfassungsspule (Ls1-Lsx) mit einer Stromversorgung (13) und Anlegen eines ersten elektrischen Signals an die Erfassungsspule, um einen elektrischen Strom in der mindestens einen elektromagnetischen Induktionsspule (Lp1-Lpx) zu induzieren, und
Trennen der Erfassungsspule (Ls1-Lsx) von der Stromversorgung (13), **dadurch gekennzeichnet, dass** die Erfassungsschaltung konfiguriert ist, um eine Frequenz eines zweiten elektrischen Signals, das nach dem ersten elektrischen Signal in der Erfassungsspule (Ls1-Lsx) induziert wird, zu bestimmen.

2. Gerät nach Anspruch 1, wobei die Erfassungsschaltung (121) konfiguriert ist, um ein Signal abzutasten, das repräsentativ für einen magnetischen Fluss ist, der aufgrund des in der mindestens einen elektromagnetischen Induktionsspule (Lp1-Lpx) induzierten elektrischen Stroms, in der Erfassungsspule (Ls1-Lsx) induziert wird.

3. Gerät nach Anspruch 1 oder 2, wobei die mindestens eine elektromagnetische Induktionsspule (Lp1-Lpx) und die Erfassungsspule (Ls1-Lsx) elektrisch isoliert sind.

4. Gerät nach irgendeinem der vorhergehenden Ansprüche, umfassend eine Steuerung, die konfiguriert ist, um die mindestens eine elektromagnetische Induktionsspule außer Betrieb zu setzen als Reaktion darauf, dass die Erfassungsvorrichtung (12, 22) einen Fehlerzustand der mindestens einen elektromagnetischen Induktionsspule (Lp1-Lpx) bestimmt,.

5. Gerät nach irgendeinem der vorhergehenden Ansprüche, ferner umfassend eine Recheneinheit, die konfiguriert ist, um eine Messung der Frequenz mit einem Referenzwert, der repräsentativ für einen Zustand ohne Kurzschluss der mindestens einen elektromagnetischen Induktionsspule ist, zu vergleichen.

6. Gerät nach irgendeinem der vorhergehenden Ansprüche, das konfiguriert ist, um die Erfassungsschaltung (121) zu betreiben, während die mindestens eine elektromagnetische Induktionsspule (Lp1-Lpx) in einem inaktiven Zustand ist.

7. Gerät nach Anspruch 6, umfassend eine erste Stromversorgung, die konfiguriert ist, um mit der mindestens einen elektromagnetischen Induktionsspule (Lp1-Lpx) verbunden zu sein, eine zweite Stromversorgung (13), die konfiguriert ist, um mit der Erfassungsspule (Ls1-Lsx) verbunden zu sein, und eine Steuerung, die konfiguriert ist, um die Erfassungsspule mit der zweiten Stromversorgung zu verbinden, während die mindestens eine elektromagnetische Induktionsspule von der ersten Stromversorgung getrennt ist, wobei vorzugsweise ein Spannungspegel der ersten Energieversorgung höher ist als ein Spannungspegel der zweiten Energieversorgung, vorzugsweise mindestens 50 V, bevorzugter 100 V höher, noch bevorzugter mindestens 150 V höher, vorzugsweise wobei ein Spannungspegel der zweiten Energieversorgung (13) 60 V oder weniger, vorzugsweise zwischen 5 V und 50 V ist.

8. Gerät nach irgendeinem der vorhergehenden Ansprüche, wobei das erste elektrische Signal ein Spannungsschritt ist.

9. Gerät nach irgendeinem der vorhergehenden Ansprüche, wobei das erste elektrische Signal ein Impulssignal ist.

10. Gerät nach irgendeinem der vorhergehenden Ansprüche, wobei die mindestens eine elektromagnetische Induktionsspule oder die Erfassungsspule oder beide als Resonanzkreis gebildet sind.

11. Gerät nach Anspruch 10, wobei die Erfassungsschaltung eine digitale Schaltung, die konfiguriert ist, um ein Timing von Nulldurchgängen des zweiten elektrischen Signals zu erfassen, umfasst.

12. Gerät nach irgendeinem der vorhergehenden Ansprüche, wobei die Erfassungsvorrichtung (12, 22) eine Leiterplatte umfasst und die Erfassungsspule (Ls1-Lsx) durch eine Leiterbahn auf der Leiterplatte gebildet wird.

13. Gerät nach irgendeinem der vorhergehenden Ansprüche, wobei die mindestens eine elektromagnetische Induktionsspule (Lp1-Lpx) eine Spule eines Elektromotors ist.

14. Gerät nach Anspruch 13, das ein Linearmotor ist, wobei die Vorrichtung eine Vielzahl von Statorspulen und eine Permanentmagnet-Bewegungseinheit umfasst, wobei jede der Vielzahl von Statorspulen die mindestens eine elektromagnetische Induktionsspule (Lp1-Lpx) umfasst.

15. Gerät nach irgendeinem der Ansprüche 1 bis 12, wobei die mindestens eine elektromagnetische Induktionsspule (Lp1-Lpx) eine Spule eines Transformators ist.

## Revendications

1. Appareil (20), comprenant :
au moins une bobine à induction électromagnétique (Lp1-Lpx), et
un dispositif de détection (22) pour détecter un court-circuit dans l'au moins une bobine à induction électromagnétique,
dans lequel le dispositif de détection comprend une bobine de détection (Ls1-Lsx) indépendante de l'au moins une bobine à induction électromagnétique et un circuit de détection (121) couplé à la bobine de détection,
dans lequel la bobine de détection (Ls1-Lsx) est agencée de sorte que la bobine de détection est couplée de façon inductive à l'au moins une bobine à induction électromagnétique (Lp1-Lpx), et
dans lequel le circuit de détection (121) est configuré pour :
connecter la bobine de détection (Ls1-Lsx) à une alimentation électrique (13) et appliquer un premier signal électrique à la bobine de détection afin d'induire un courant électrique dans l'au moins une bobine à induction électromagnétique (Lp1-Lpx), et
déconnecter la bobine de détection (Ls1-Lsx) de l'alimentation électrique (13), **caractérisé en ce que** le circuit de détection est configuré pour déterminer une fréquence d'un deuxième signal électrique induit dans la bobine de détection (Ls1-Lsx) suivant le premier signal électrique.

2. Appareil selon la revendication 1, dans lequel le circuit de détection (121) est configuré pour détecter un signal représentatif d'un flux magnétique induit dans la bobine de détection (Ls1-Lsx) sous l'effet du courant électrique induit dans l'au moins une bobine à induction électromagnétique (Lp1-Lpx).

3. Appareil selon la revendication 1 ou 2, dans lequel l'au moins une bobine à induction électromagnétique (Lp1-Lpx) et la bobine de détection (Ls1-Lsx) sont électriquement isolées.

4. Appareil selon l'une quelconque des revendications précédentes, comprenant un dispositif de commande configuré pour rendre l'au moins une bobine à induction électromagnétique inopérante en réponse au dispositif de détection (12, 22) déterminant un état de défaut de l'au moins une bobine à induction électromagnétique (Lp1-Lpx).

5. Appareil selon l'une quelconque des revendications précédentes, comprenant en outre une unité informatique configurée pour comparer une mesure de la fréquence à une valeur de référence représentative d'un état sans court-circuit de l'au moins une bobine à induction électromagnétique.

6. Appareil selon l'une quelconque des revendications précédentes, configuré pour actionner le circuit de détection (121) tandis que l'au moins une bobine à induction électromagnétique (Lp1-Lpx) est dans un état inactif.

7. Appareil selon la revendication 6, comprenant une première alimentation électrique configurée pour être connectée à l'au moins une bobine à induction électromagnétique (Lp1-Lpx), une deuxième alimentation électrique (13) configurée pour être connectée à la bobine de détection (Ls1-Lsx), et un dispositif de commande configuré pour connecter la bobine de détection à la deuxième alimentation électrique tandis que l'au moins une bobine à induction électromagnétique est déconnectée de la première alimentation électrique, de préférence dans lequel un niveau de tension de la première alimentation électrique est supérieur à un niveau de tension de la deuxième alimentation électrique, de préférence au moins 50 V, plus préférablement 100 V plus élevée, encore plus préférablement au moins 150 V plus élevée, de préférence dans lequel un niveau de tension de la deuxième alimentation électrique (13) est de 60 V ou moins, de préférence entre 5 V et 50 V.

8. Appareil selon l'une quelconque des revendications précédentes, dans lequel le premier signal électrique est un échelon de tension.

9. Appareil selon l'une quelconque des revendications précédentes, dans lequel le premier signal électrique est un signal d'impulsion.

10. Appareil selon l'une quelconque des revendications précédentes, dans lequel l'une ou les deux parmi l'au moins une bobine à induction électromagnétique et la bobine de détection est formée sous la forme d'un circuit résonant.

11. Appareil selon la revendication 10, dans lequel le circuit de détection comprend un circuit numérique configuré pour détecter une temporisation de passages par zéro du deuxième signal électrique.

12. Appareil selon l'une quelconque des revendications précédentes, dans lequel le dispositif de détection (12, 22) comprend une carte de circuit imprimé et la bobine de détection (Ls1-Lsx) est formée d'un tracé conducteur sur la carte de circuit imprimé.

13. Appareil selon l'une quelconque des revendications précédentes, dans lequel l'au moins une bobine à induction électromagnétique (Lp1-Lpx) est une bobine d'un moteur électrique.

14. Appareil selon la revendication 13, étant un moteur linéaire, l'appareil comprenant une pluralité de bobines de stator et une unité de déplacement d'aimant permanent, dans lequel chacune de la pluralité de bobines de stator comprend l'au moins une bobine à induction électromagnétique (Lp1-Lpx).

15. Appareil selon l'une quelconque des revendications 1 à 12, dans lequel l'au moins une bobine à induction électromagnétique (Lp1-Lpx) est une bobine d'un transformateur.
